# EUROPEAN PATENT SPECIFICATION

(11) **EP 2 147 740 B1**
(45) Date of publication and mention of the grant of the patent: **20.05.2015**
(21) Application number: 09175462.2
(22) Date of filing: 01.03.2001
(51) Int. Cl.: B23K 35/26, C22C 13/00

(54) **Lead-free solder paste**
Bleifreie Lötpaste
Pâte à souder sans plomb

(43) Date of publication of application: 27.01.2010
(62) Divisional of application: 01400534.2
(73) Proprietor: Senju Metal Industry Co., Ltd, Tokyo 120-8555 (JP)
(72) Inventor: Katoh, Rikiya, SAITAMA (JP); Munekata, Osamu, Tochigi, 329-0618 (JP); Toyoda, Yoshitaka, SAITAMA (JP)
(74) Representative: Zimmermann & Partner Patentanwälte mbB

(56) References cited:
- EP-A- 0 251 611
- EP-A- 0 499 452
- EP-A- 0 710 521
- WO-A-00/48784
- JP-A- 9 155 586
- JP-A- 09 327 790
- JP-A- 10 193 169
- JP-A- 10 314 980
- US-A- 4 670 217
- US-A- 6 139 979
- LAINE-YLIJOKI T ET AL: "DEVELOPMENT AND VALIDATION OF A LEAD-FREE ALLOY FOR SOLDER PASTE APPLICATIONS" IEEE TRANSACTIONS ON COMPONENTS, PACKAGING AND MANUFACTURING TECHNOLOGY. PART C: MANUFACTURING, IEEE SERVICE CENTER, PISCATAWAY, NJ, US, vol. 20, no. 3, PART C, 1 July 1997 (1997-07-01), pages 194-198, XP000722468 ISSN: 1083-4400

## Description

### Background of the Invention

### 1. Field of the Invention

This invention relates to a lead-free solder paste which is used for reflow soldering of leadless chip components and which can prevent the occurrence of tombstoning during reflow soldering.

### 2. Description of the Related Art

Among soldering methods commonly in use today, the reflow soldering method is particularly suitable for bonding extremely small electronic components to printed circuit boards. In reflow soldering, a solder paste containing a fine solder powder and a flux is applied to selected areas of a printed circuit board by screen printing through a metal mask or silk screen. Electronic devices are then mounted on the applied solder paste and temporarily held in place on the printed circuit board by the stickiness of the solder paste. The printed circuit board and the electronic devices are then heated, usually in a furnace, to melt the solder powder in the paste. The molten paste is then cooled to solidity the molten solder, thereby forming soldered joints between the electronic devices and the circuit board.

The reflow soldering method enables minute electronic devices to be precisely positioned on a printed circuit board, and there is no undesired bridging of solder between adjoining electronic devices, so it can produce printed circuit boards of high accuracy and reliability. This method also has excellent productivity.

However, one problem which has been encountered when soldering minute electronic components to printed circuit boards by reflow soldering is the phenomenon of tombstoning (also reterred to as the Manhattan phenomenon). In this phenomenon, one end of an electronic device becomes detached from a printed circuit board during reflow while its opposite end remains bonded to the circuit board, as a result of which the one end rises and the electronic device assumes a more or less vertical orientation. Tombstoning is caused by a difference in the time at which solder paste is melted at opposite ends of an electronic device during heating in a reflow furnace. The surface tension which molten solder exerts on an electronic component is greater than the adhesive force exerted by the tackiness of the solder in an unmelted state. Accordingly, if solder paste at a first end of an electronic device melts while the solder paste at a second end of the device is still unmelted, the surface tension exerted by the molten solder at the first end exerts a downward force on the first end which may be strong enough to detach the second end of the electronic device from the printed circuit board and cause the second end to swing upwards about the first end. When an electronic device undergoes tombstoning, the second end of the electronic device is not electrically connected to the printed circuit board, so the device cannot function properly. Tombstoning is particularly a problem with leadless chip components, which are extremely small and commonly have maximum dimensions less than a millimeter, making them very susceptible to tombstoning when there is an imbalance in the forces acting on their ends during reflow soldering.

It has been discovered that tombstoning can be prevented by the use of a twin-peak solder alloy, which is an alloy which has two peaks in a DSC (differential scanning calorimeter) curve between its solidus and liquidus temperatures, with some phase transformation occurring at the temperature of each peak. In contrast, a eutectic solder alloy has only a single peak in a DSC curve between its solidus and liquidus temperatures.

However, twin-peak solder alloys which have been proposed thus far for use in solder pastes are lead-containing solders. For example, U.S. Patent No. 6,050,480 discloses twin-peak solder alloys containing up to nearly 40 mass % of lead.

In recent years, there has been a movement in the electronics industry away from the use of lead-containing solders due to the environmental damage which can occur when electronic equipment employing lead-containing solders is discarded in landfills and lead in the solder leaches into the water supply.

Accordingly, there is a great need by the electronics industry for a lead-free solder paste which is suitable for reflow soldering of electronic devices without the occurrence of tombstoning.

### Summary of the Invention

The present invention provides a lead-free solder paste which is used for reflow soldering without causing tombstoning according to the use defined in claim 1.

According to one aspect related to the invention, a solder paste comprises a mixture of a powder of a lead-free Sn-based solder alloy and a flux mixed with the powder. The solder alloy is a twin-peak solder having two peaks in a DSC curve between its solids and liquidus temperatures and contains 0.2 - 1.0 mass % of Ag. The first peak occurs at the start of melting of the alloy, and the second peak occurs at a higher temperature than the first peak when the major portion of the solder alloy subsequently melts. Preferably the magnitude of the first peak is less than or equal to the magnitude of the second peak.

The solder alloy may include various additional components, such as a strength improving element, a melting point lower element, or an oxidation preventing element.

According to another aspect related to the invention, a soldering method comprises performing reflow soldering of electronic devices to a printed circuit board using a solder paste according to the present invention.

The present invention relates to

the reflow soldering of leadless chip components.

### Brief Description of the Drawings

Figure 1 is a DSC (differential scanning calorimeter) curve of a Sn-0.5Ag solder alloy.
Figure 2 is a DSC curve of a Sn-1Ag solder alloy.
Figure 3 is a DSC curve of a Sn-0.5Ag-0.1Ni solder alloy.
Figure 4 is a DSC curve of a Sn-1Ag-0.1P solder alloy.
Figure 5 is a DSC curve of a Sn-3.5Ag solder alloy.
Figure 6 is a DSC curve of a Sn-2Ag-0.5Cu solder alloy.

### Description of Preferred Embodiments

A twin-peak solder alloy such as is used in a solder paste according to the present invention is thought to prevent tombstoning by undergoing gradual melting over a range of temperatures and thereby prolonging the time during which melting takes place. With a eutectic solder alloy, if solder begins melting at different times at opposite ends of an electronic device, the solder at one end of the electronic device may reach completely melted state while the solder at the opposite end of the electronic device is still in an unmelted state. In this case, the solder in a completely melted state will exert a much greater tensile force on the electronic device than the unmelted solder, and the imbalance in tensile forces may cause tombstoning of the electronic device. With a twin-peak solder alloy, the forces acting on opposite ends of an electronic device during melting of the solder can be balanced so as to prevent combstoning. If the solder at a first end of an electronic device begins to melt before the solder at the second end, since melting takes gradually, before the solder at the first end has completely melted, the solder at the second end begins to melt, so a state is achieved in which the solder at both ends is in a half-melted state. Namely, when the solder at the first end bogins to melt, it exerts a weak surface tension in a half-melted state, but the surface tension in this state is not large enough to overcome the adhesive force acting on the second of the electronic device by the unmelted solder at the second end. When the solder at the second end begins to melt, it exerts a weak surface tension on the second end, which is stronger than the adhesive force which it exerted in an unmelted state. When the solder at the first end subsequently reaches a completely molten state, it exerts a stronger surface tension on the first end. However, the surface tension exerted by the half-melted solder at the second end is sufficiently great to resist the stronger surface tension exerted by the completely melted solder at the first end, so no tombstoning takes place.

Thus, a twin-peak solder can prevent tombstoning during reflow soldering by achieving a balance between the tensile forces acting on opposite ends of an electronic device. It is thought that tombstoning can be most effectively prevented when the ratio of the tensile forces acting on opposite ends of an electronic device during melting of solder is at most approximately 0.5.

If the solidification temperature range (the difference between the liquidus and solidus temperatures) for a twin-peak solder alloy is too small, tombstoning cannot be prevented, since the melting behavior of the solder alloy will resemble that of a eutectic solder alloy. On the other hand, if the solidification temperature range is very broad, a long time is required for melting, which may result in corrosion of electrodes or the growth of undesirable compounds in the regions being soldered, producing a decreaae in the strength of the bonding interface. A large solidification range also prolongs the length of time required for solidification, increasing the chances of cracks being produced in soldered joints by vibrations or impacts applied to the joints during the process of solidification. Therefore, the solidification range of a twin-peak solder alloy used in a solder paste according to the present invention is preferably in the range of approximately 10 to 15 °C.

Preferably the first peak of heat absorption in the DSC curve of a twin-peak solder alloy used in the present invention is less than or equal in magnitude to the second peak, since this is advantageous in causing the forces acting on an electronic device due to the surface tension of molten solder to gradually increase as melting proceeds. However, the desired effect cannot be obtained when the first peak is extremely small. Tombstoning can most effectively be prevented when the first and second peaks of heat absorption are approximately equal in magnitude.

The melting point of the Sn-based solder alloy may be 220°C or above.

The Sn content of the solder alloy is not restricted but will typically be 90 mass % or above. The Ag content of the solder alloy is preferably 0.2 - 1.0 mass %. If the Ag content of the solder alloy is less than 0.2 mass %, the first peak of heat absorption becomes extremely small compared to the second peak. In this case, very little force due to surface tension acts on an electronic device at the temperature of the first peak, and the force due to surface tension suddenly increases at the second peak, so there is an inadequate balance between the forces acting on opposite ends of an electronic device, and tombstoning cannot be effectively prevented. On the other hand, if the solder alloy contains more than 1.0 mass % of Ag, the first peak of heat absorption in the DSC curve becomes significantly larger than the second peak, and the second peak substantially disappears. In this case as well, an imbalance develops between the forces due to surface tension action on opposite ends of an electronic device, and tombstoning cannot be effectively prevented.

The solder alloy may consist essentially of Sn and Ag, but it may also comprise a variety of additional element for providing the alloy with desired properties. For examples, it may include one or more elements selected from strength improving elements to improve mechanical properties, melting temperature lowering elements to lower the melting temperature of the solder alloy to avoid thermal damage and deterioration in performance of electronic devices due to high temperatures, and oxidation preventing elements to prevent oxidation of the solder alloy during heating at the time of reflow soldering.

Examples of strength improving elements include Sb, Cu, Ni, Ce, Fe, Mn, Cr, and Mo, one or more of which may be employed. Any one of these meals forms a solid solution or an intermetallic compound with Sn to improve mechanical strength. if the amount of these elements which is added is too large, the liquidus temperature of the solder alloy undesirably increases. Therefore, the total amount of Sb and Cu is preferably at most 1% or the total mass of the solder alloy, while the total amount of Ni, Co, Fe, Mn, Cr, and Mo is preferably at most 0.3% of the total mass of the solder alloy.

Examples of elements which are effective in lowering the rerlow soldering temperature include one or more of Bi, In, and Zn. The total amount of these elements is preferably at least 0.5 mass % and at most 3 mass % of the total mass of the solder alloy.

Examples of oxidation preventing elements include one or more of P, Ga, and Ge. If too large a quantity of these elements is added, the liquidus temperature of the solder alloy undesirably increases, so the total amount of these elements is preferably at most 0.2 mass % of the total mass of the solder alloy.

A solder paste for use according to the present invention may be prepared by mixing the solder powder with a viscous flux in a conventional manner. Normally the solder powder will have a particle size between 100 and 400 mesh. Such a solder powder may be prepared by any appropriate technique, including inert gas (e.g., argon or nitrogen gas) atomization and centrifugal spraying, for example.

The viscous flux to be mixed with the solder powder may be either a non-water soluble flux or a water-soluble flux. A typical non-water soluble flux is a rosin-based flux, but other non-water soluble fluxes may be used. The rosin may be either polymerized or unpolymerized. The flux normally comprises a base material such as a rosin, a small amount of an activator, and optionally a thixotropic agent in a solvent. Examples of an activator for rosin include amine hydrohalide salts, amine organic acid salts, and organic acids. Examples of a thixotropic agent include hydrogenated castor oil. Solvents useful for non-water soluble fluxes include glycol ethers, lower alcohols, and terpene.

The proportions of the solder powder and the flux are typically selected so as to give a mixture having a consistency suitable for printing. Generally, the weight ratio of the solder powder to the flux is in the range of from 80:20 to 95:5 and preferably from 85:15 to 92:8.

The solder paste can be applied to selected areas on a printed circuit board by screen printing or other convenient method. After electronic devices are mounted on the applied solder paste, the circuit board is heated in a reflow furnace to melt the solder alloy, thereby bonding the electronic devices to the circuit board.

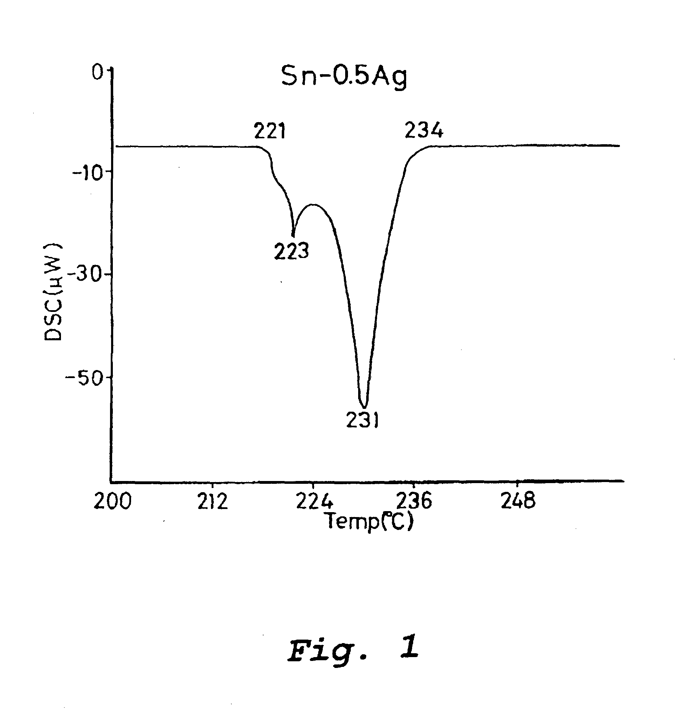

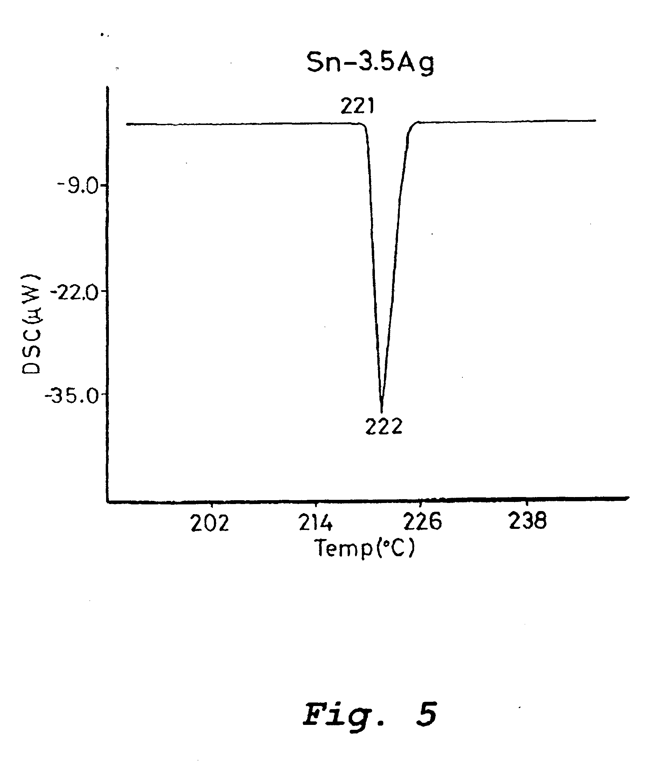

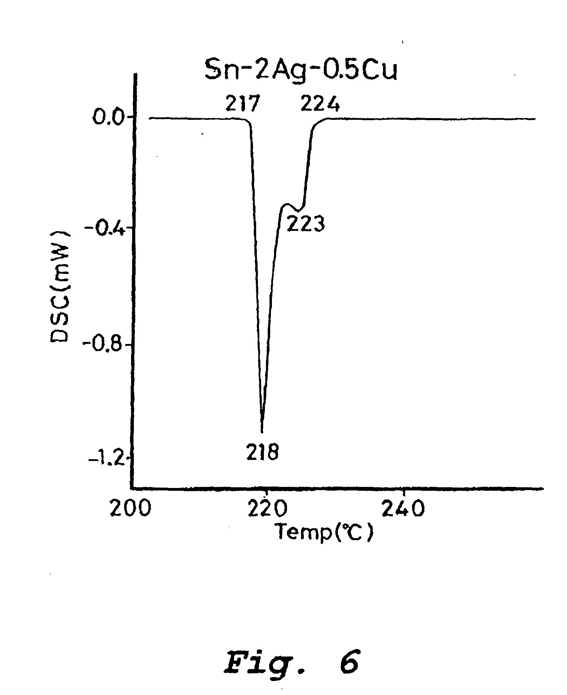

Figures 1-4 are DSC curves of lead-free solder alloys suitable for use in a solder paste according to the present invention, and Figures 5 and 6 are DSC curves of comparatives examples of lead-free solder alloys.

First, the lead-free solder alloys of Figure 5 and Figure 6 will be explained. Figure 5 is a DSC curve of a eutectic Sn-3.5Ag solder alloy, and Figure 6 is a DSC curve for a Sn-2Ag-0.5Cu solder alloy.

Since the Sn-3.5Ag solder alloy of Figure 5 is a binary eutectic alloy, it has only a single large peak of heat absorption at 222°C, slightly above the eutectic temperature of 221°C When reflow soldering is performed using this solder, the force due to surface tension acting on an end of an electronic device being soldered suddenly increases at the heat absorption peak of 222°C, and tombstoning can easily take place.

The Sn-2Ag-0.5Cu solder alloy of Figure 6 begins to melt at 217°C, a first large peak of heat absorption appears immediately thereafter at 218°C, and the major portion of the solder alloy begins to melt. A second peak of heat absorption then appears at 223°C and the remaining portion melts, and then the solder alloy entirely completes melting at 224°C, so it exhibits two peaks of heat absorption in its DSC curve. However, the first peak is much larger than the second peak, and the force due to surface tension suddenly increases at the first peak, so when this solder alloy is used for reflow soldering, an imbalance develops between the forces acting on opposite ends of an electronic device being soldered, and there is a significant likelihood of tombstoning taking place.
Figure 1 is a DSC curve for a Sn-0.5Ag lead-free solder alloy. It begins melting at 221°C, a first large peak of heat absorption appears immediately thereafter at 223°C, a second peak of heat absorption which is larger then appears at 231°C, and melting is entirely completed at 234°C.

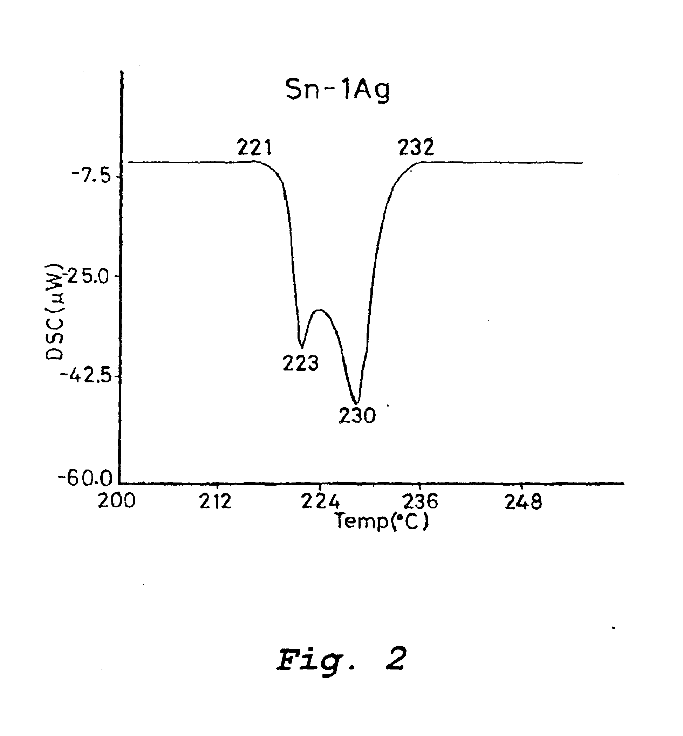

Figure 2 is a DSC curve for a Sn-1Ag lead-free solder alloy. It begins melting at 221°C, a first large peak of heat absorption appears immediately thereafter at 223°C, a second large peak of heat absorption then appears at 230°C, and melting is entirely completed at 232°C.

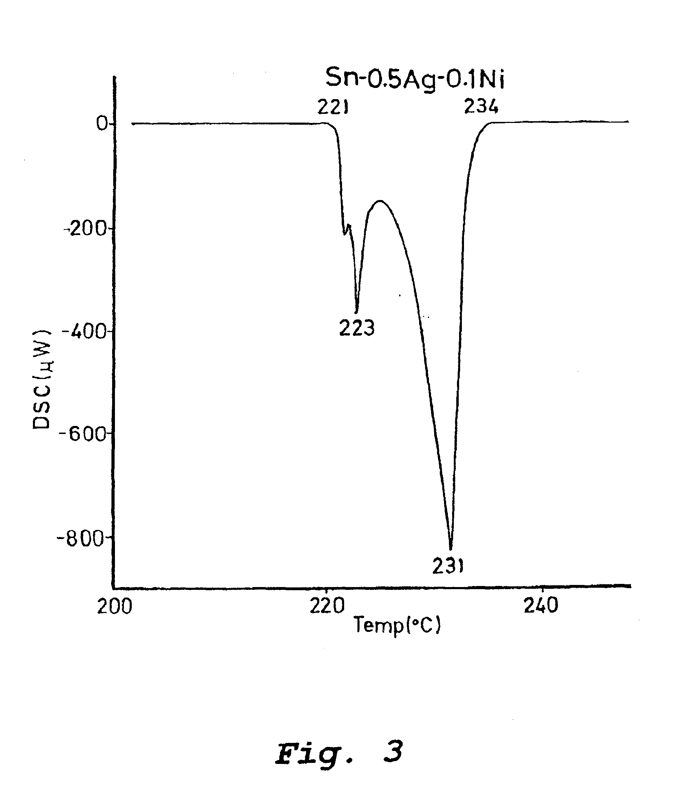

Figure 3 is a DSC curve for a Sn-0.5Ag-0.1Ni lead-free solder alloy. It begins to melt at 221°C, a first large peak of heat absorption appears immediately thereafter at 223°C, a second peak of heat absorption which is larger than the first peak then appears at 231°C, and melting is entirely completed at 234°C.

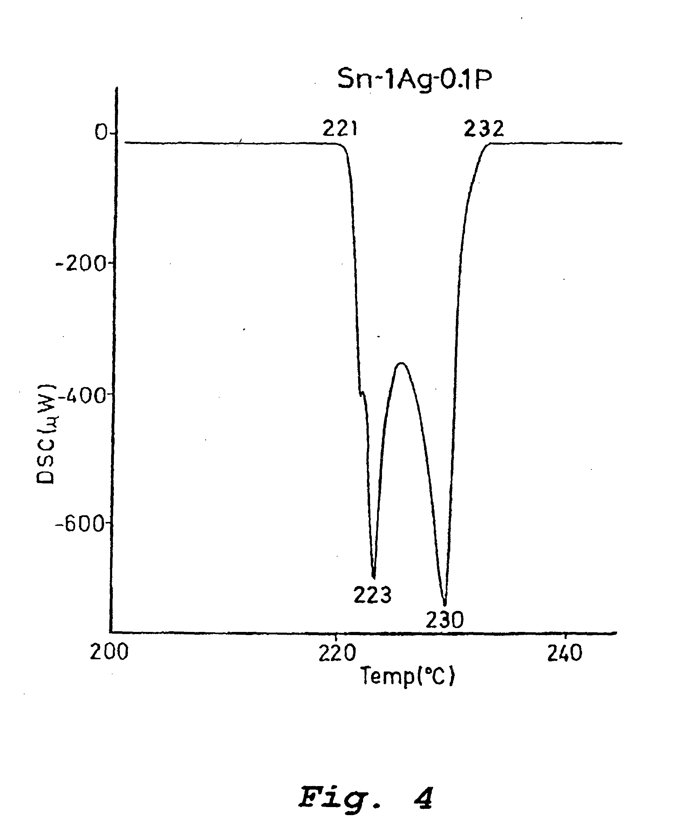

Figure 4 is a DSC curve for a Sn-1Ag-0.1P lead-free solder alloy. It begins to melt at 221°C, a first large peak of heat absorption appears immediately thereafter at 223°C, a second large peak of heat absorption then appears at 230°C, and melting is entirely completed at 232°C.

Each of the solder alloys of Figures 1 - 4 is a twin-peak alloy with two peaks of heat absorption in a DSC curve between its solidus and liquidus temperatures, with the first peak being less than or equal in magnitude than the second peak and occurring at the start of melting, and the major portion of melting occurs at the second peak. Therefore, each of these alloys exhibits a gradual melting pattern which can effectively prevent tombstoning.

### Examples

The following examples illustrate the performance of a lead-free solder paste for use according to the present invention and of comparative examples of a lead-free solder paste when used in reflow soldering.

### Example 1

In this example, powder of a high temperature solder alloy containing 0.5% Ag and a remainder of Sn (average particle diameter of 30µm) was mixed with a conventional resin-type flux in the following proportions to obtain a solder paste.

| | |
|---|---|
| Lead-free solder alloy powder: Sn-0.5Ag | 90 mass % |
| Paste-type flux: | 10 mass % |

Figure 1 is a DSC curve of the solder alloy of this example.

### Example 2

A solder paste having the composition described below was obtained in the same manner as in Example 1.

| | |
|---|---|
| Lead-free solder alloy powder: Sn-1Ag-0.1Ni | 90 mass % |
| Paste-type flux: | 10 mass % |

### Comparative Example 1

In this example, the procedure of Example 1 was repeated to obtain a solder paste having the following composition.

| | |
|---|---|
| Lead-free solder alloy powder: Sn-3.5Ag | 90 mass % |
| Paste-type flux: | 10 mass % |

Figure 5 is a DSC curve for the solder alloy of this examples.

### Comparative Example 2

In the same manner as in Comparative Example 1, a solder paste having the following composition was obtained.

| | |
|---|---|
| Lead-free solder alloy powder: Sn-2Ag-0.5Cu | 90 mass % |
| Paste-type flux: | 10 mass % |

Figure 6 is a DSC curve for the solder alloy of this example.

A tombstoning test was carried out using the solder pastes of the above-described examples of the present invention and comparative examples. In the tombstoning test, solder was applied by printing using a mask on a printed circuit board, and then 1600 type 1500 chip components (having rectangular dimension of 1 mm in length and 0.5 mm in width) were mounted on the rogions of the printed circuit board where the solder paste had been applied. The printed circuit board and the chip components were heated in a reflow furnace to melt the solder paste and solder the chip components to the printed circuit board. After soldering, the number of chip components which had undergone tombstoning was counted.

There was no tombstoning of any of the chip components soldered using the solder pastes of Example 1 and Example 2 according to the present invention. In contrast, 13 chip components underwent tombstoning for Comparative Example 1, and 6 chip components underwent tombstoning for Comparative Example 2, illustrating the high reliability of a lead-free solder paste for use according to the present invention compared to conventional lead-free solder pastes.

## Claims

1. Use of a Pb-free solder paste consisting of a mixture of a powder of a lead-free Sn-based twin-peak solder alloy powder and a flux for preventing tombstoning during reflow soldering of leadless chip components, the solder alloy consisting of 0.2 -1.0 mass percent of Ag, optionally at least one of the below-listed (i)-(iv), and the balance of Sn:
(i) at least one element selected from the group consisting of Bi, In, and Zn in a total amount of at least 0.5 mass percent and at most 3 mass percent,
(ii) at least one element of Sb and Cu in a total amount of at most 1 mass percent,
(iii) at least one element selected from the group consisting of Ni, Co, Fe, Mn, Cr and Mo in a total amount of at most 0.3 mass percent; and
(iv) at least one element selected from the group consisting of P, Ga, and Ge in a total amount of at most 0.2 mass percent.

## Patentansprüche

1. Verwendung einer bleifreien Lötpaste, bestehend aus einer Mischung aus einem Pulver eines bleifreien Sn-basierten Doppelspitzen-Lötlegierungspulvers und einem Flussmittel zur Vermeidung des Grabsteineffekts beim Reflow-Löten von Chipkomponenten ohne Anschlussbeine, wobei die Lötlegierung aus 0.2 -1.0 Masseprozent Ag, optional mindestens einem der nachstehend aufgeführten (i) -(iv) und Sn als Rest besteht:
(i) mindestens ein Element, ausgewählt aus der Gruppe, die aus Bi, In und Zn besteht, in einer Gesamtmenge von mindestens 0,5 Masseprozent und höchstens 3 Masseprozent,
(ii) mindestens ein Element von Sb und Cu in einer Gesamtmenge von höchstens 1 Masseprozent,
(iii) mindestens ein Element, ausgewählt aus der Gruppe, die aus Ni, Co, Fe, Mn, Cr und Mo besteht, in einer Gesamtmenge von höchstens 0,3 Masseprozent; und
(iv) mindestens ein Element, ausgewählt aus der Gruppe, die aus P, Ga und Ge besteht, in einer Gesamtmenge von höchstens 0,2 Masseprozent.

## Revendications

1. Usage d'une pâte à braser sans plomb consistant en un mélange d'une poudre d'alliage à braser à double pic à base de Sn sans plomb et d'un flux pour éviter le phénomène de tombstoning pendant le brasage par reflux de composants de puce sans broches, l'alliage à braser consistant en 0,2 à 1,0 % en masse d'Ag, en option au moins l'un des éléments (i) à (iv) énumérés ci-dessous, le reste étant du Sn:
(i) au moins un élément choisi dans le groupe consistant en Bi, In et Zn en une quantité totale d'au moins 0,5 % en masse et d'au plus 3 % en masse;
(ii) au moins un élément de Sb et Cu en une quantité totale d'au plus 1 % en masse;
(iii) au moins un élément choisi dans le groupe consistant en Ni, Co, Fe, Mn, Cr et Mo en une quantité totale d'au plus 0,3 % en masse;
(iv) au moins un élément choisi dans le groupe consistant en P, Ga et Ge en une quantité totale d'au plus 0,2 % en masse.
